# EUROPEAN PATENT APPLICATION

(11) **EP 1 641 045 A2**
(43) Date of publication of application: **29.03.2006**
(21) Application number: 05021614.2
(22) Date of filing: 12.11.2003
(51) Int. Cl.: H01L 27/146, H01L 27/148

(54) **Grounded gate and isolation techniques for reducing dark current in CMOS image sensors**

(30) Priority: 12.11.2002 US 291728; 12.11.2002 US 291772
(62) Divisional of application: 03786643.1
(71) Applicant: MICRON TECHNOLOGY, INC., Boise, ID 83707-0006 (US)
(72) Inventor: Mouli, Chandra, Boise 83712 Idaho (US); Rhodes, Howard, Boise 83706 Idaho (US)
(74) Representative: Collins, John David

(57) **Abstract**

Isolation methods and devices for isolating regions of a semiconductor device. The isolation structure and methods include forming a biased gate over a field isolation region and adjacent a pixel of an image sensor. The isolation methods also include forming an isolation gate over substantial portions of a field isolation region to isolate pixels in an array of pixels. The isolation method and structure further include forming an isolating trench in an active area and filling the trench with a doped conductive material containing silicon. There is also provided a method and structure for isolating the regions by providing a trench in an active area of a substrate, growing an epitaxial layer in the trench to fill the trench or to partially fill the trench and depositing an insulating material over the epitaxial layer and within the trench to completely fill the trench.

## Description

### FIELD OF THE INVENTION

The present invention relates generally to semiconductor devices, and more particularly, to trench isolation technology for use in semiconductor devices, including CMOS image sensors.

### BACKGROUND OF THE INVENTION

In silicon integrated circuit (IC) fabrication, it is often necessary to isolate semiconductor devices formed in the substrate. This is true for many semiconductor memory devices, for example, DRAM, flash memory, SRAM, microprocessors, DSP and ASIC. The individual pixels of a CMOS image sensor also need to be isolated from each other.

A CMOS image sensor circuit includes a focal plane array of pixel cells, each one of the cells including a photogate, photoconductor, or photodiode overlying a charge accumulation region within a substrate for accumulating photo-generated charge. Each pixel cell may include a transistor for transferring charge from the charge accumulation region to a floating diffusion node and a transistor, for resetting the diffusion node to a predetermined charge level prior to charge transference. The pixel cell may also include a source follower transistor for receiving and, amplifying charge from the diffusion node and an access transistor for controlling the readout of the cell contents from the source follower transistor.

In a CMOS image sensor, the active elements of a pixel cell perform the necessary functions of: (1) photon to charge conversion; (2) accumulation of image charge; (3) transfer of charge to the floating diffusion node accompanied by charge amplification; (4) resetting the floating diffusion node to a known state before the transfer of charge to it; (5) selection of a pixel for readout; and (6) output and amplification of a signal representing pixel charge from the floating diffusion node. Photo charge may be amplified when it moves from the initial charge accumulation region to the floating diffusion node. The charge at the floating diffusion node is typically converted to a pixel output voltage by a source follower output transistor. The photosensitive element of a CMOS image sensor pixel is typically either a depleted p-n junction photodiode or a field induced depletion region beneath a photogate. A photon impinging on a particular pixel of a photosensitive device may diffuse to an adjacent pixel, resulting in detection of the photon by the wrong pixel, i.e. cross-talk. Therefore, CMOS image sensor pixels must be isolated from one another to avoid pixel cross talk. In the case of CMOS image sensors, which are intentionally fabricated to be sensitive to light, it is advantageous to provide both electrical and optical isolation between pixels.

CMOS image sensors of the type discussed above are generally known as discussed, for example, in Nixon et al., "256.times.256 CMOS Active Pixel Sensor Camera-on-a-Chip," IEEE Journal of Solid-State Circuits, Vol. 31(12), pp. 2046-2050 (1996); and Mendis et al., "CMOS Active Pixel Image Sensors," IEEE Transactions on Electron Devices, Vol. 41(3), pp. 452-453 (1994). See also U.S. Patent Nos. 6,177,333 and 6,204,524, which describe operation of conventional CMOS image sensors, the contents of which are incorporated herein by reference.

Shallow trench isolation (STI) is one technique, which can be used to isolate pixels, devices or circuitry from one another. In general, a trench is etched into the substrate and filled with a dielectric to provide a physical and electrical barrier between adjacent pixels, devices, or circuitry. Refilled trench structures, for example, are formed by etching a trench by a dry anisotropic or other etching process and then filling it with a dielectric such as a chemical vapor deposited (CVD) silicon dioxide (SiO₂). The filled trench is then planarized by an etch-back process so that the dielectric remains only in the trench and its top surface remains level with that of the silicon substrate. The depth of a shallow trench is generally from about 2000 to about 2500 Angstroms.

One drawback associated with shallow trench isolation in the case of CMOS image sensors is cross-talk from a photon impinging on a particular pixel of a photosensitive device causing changes that may diffuse under the shallow trench isolation structure to an adjacent pixel. Another drawback is that a hole accumulation layer along the sidewall of the trench is relatively small since it is limited by the depth of the shallow trenches.

To enhance the isolation further, ions can be implanted in the silicon substrate in the area directly beneath the trench. However, a drawback associated with ion implantation beneath the trench, as noted, for example, in S. Nag et al., "Comparative Evaluation of Gap-Fill Dielectrics in Shallow Trench Isolation for Sub-0.25 .mu.m Technologies," IEEE IEDM, pp. 841-844 (1996), is that ion implantation beneath the trench can result in high current leakage. In particular, when ions are implanted in the substrate close to the edges of the trench, current leakage can occur at the junction between the active device regions and the trench.

In addition to the above-mentioned drawbacks, the dominant crystallographic planes along the trench sidewalls, which have a higher silicon density, create a higher density of trap sites along the trench sidewalls compared to silicon/gate oxide interface of a transistor at the silicon surface. Trap sites on dangling bonds or broken bonds can exist at the gate electrode/oxide interface, in the bulk oxide film, the oxide substrate interface, and/or the trench insulation/active layer interface. The trap sites are normally uncharged but become energetic when electrons and holes become trapped in the trap sites. Highly energetic electrons or holes are called hot carriers. Trapped hot carriers can contribute to the fixed charge of the device and change the threshold voltage and other electrical characteristics of the device. As a result of these trap sites formed along the trench sidewalls, current generation near and along the trench sidewalls can be very high. Generation current from trap sites inside or near the photodiode depletion region contributes to the total dark current. Minimizing dark current in the photodiode is important in CMOS image sensor fabrication.

Accordingly, it is desirable to provide an isolation technique that prevents cross-talk between pixels while reducing dark current or current leakage as much as possible. It is also desirable to provide an isolation technique while increasing a hole accumulation region adjacent a pixel isolation region.

### BRIEF SUMMARY OF THE INVENTION

In one aspect, the invention provides an isolation gate formed over an isolation trench formed in an image sensor substrate for biasing the substrate at the sidewalls of the trench and providing improved isolation between adjacent pixels. In another aspect, the invention provides a substrate biasing isolation gate formed over a substantial portion of an isolation trench formed in an image sensor substrate and formed surrounding a substantial portion of a photosensitive region of an image sensor pixel formed in the substrate.

In yet another aspect, the invention provides a structure for isolating areas in a semiconductor device having a trench filled with a conductive material containing silicon formed in an active layer of a substrate to isolate adjacent regions. The conductive material containing silicon may be doped with n-type or p-type dopants prior to or after deposition of the material. Preferred conductive materials containing silicon include polysilicon and silicon-germanium. In a further aspect, the invention provides forming a trench adjacent an active layer of a substrate, growing an epitaxial layer to partially fill the trench and depositing an insulating material over the epitaxial layer and within the trench to completely fill the trench.

### BRIEF DESCRIPTION OF THE DRAWINGS

These and other features and advantages of the invention will be more apparent from the following detailed description that is provided in connection with the accompanying drawings and illustrate exemplary embodiments of the invention, in which:

FIG. 1A is a top plan view of an exemplary CMOS image sensor fragment;

FIG. 1B is a diagrammatic side sectional view of the FIG. 1A image sensor fragment taken along line 1B-1B;

FIG. 2A is a top plan view of a CMOS image sensor fragment in accordance with a first exemplary embodiment of the invention;

FIG. 2B is a diagrammatic side sectional view of the FIG. 2A image sensor fragment taken along line 2B-2B;

FIG. 3A is a top plan view of a CMOS image sensor fragment showing a 2x2 pixel layout in accordance with another exemplary embodiment of the invention;

FIG. 3B is a diagrammatic side sectional view of the FIG. 3A image sensor fragment taken along line 3B-3B;

FIG. 4 is a representative pixel layout showing a 1 x 1 pixel layout according to an embodiment of the invention;

FIG. 5 is a diagrammatic side sectional view of a CMOS image sensor fragment showing a trench in process in accordance with another embodiment of the invention;

FIG. 6 is a diagrammatic side sectional view of a CMOS image sensor fragment showing a trench at a processing step subsequent to that shown in FIG. 3;

FIG. 7 is a diagrammatic side sectional view of a CMOS image sensor fragment showing a trench at a processing step subsequent to that shown in FIG. 6;

FIG. 8 is a diagrammatic side sectional view of a CMOS image sensor fragment showing a trench at a processing step subsequent to that shown in FIG. 6;

FIG. 9 is a diagrammatic side sectional view of a CMOS image sensor fragment incorporating the trench of FIGS. 7 and 8;

FIG. 10 is a diagrammatic side sectional view of a CMOS image sensor fragment showing a trench in process in accordance with another exemplary embodiment of the present invention;

FIG. 11 is a diagrammatic side sectional view of a CMOS image sensor fragment showing a trench at a processing step subsequent to that shown in FIG. 10;

FIG. 12 is a diagrammatic side sectional view of a CMOS image sensor fragment showing a trench at a processing step subsequent to that shown in FIG. 11;

FIG. 13 is a diagrammatic side sectional view of a CMOS image sensor fragment showing a trench at a processing step subsequent to that shown in FIG. 12;

FIG. 14 is a diagrammatic side sectional view of a CMOS image sensor fragment showing a trench at a processing step subsequent to that shown in FIG. 13;

FIG. 15 is a diagrammatic side sectional view of a CMOS image sensor fragment showing a trench in process in accordance with yet another exemplary embodiment of the present invention at a processing step subsequent to that shown in FIG. 13;

FIG. 16 is a diagrammatic side sectional view of a CMOS image sensor fragment incorporating the trench of FIG. 15;

FIG. 17 is a diagrammatic side sectional view of a CMOS image sensor fragment incorporating the trench of FIG. 16; and

FIG. 18 is a schematic diagram of a processor system incorporating a CMOS image sensor constructed in accordance with the invention.

### DETAILED DESCRIPTION OF THE INVENTION

In the following detailed description, reference is made to the accompanying drawings, which form a part hereof, and in which is shown by way, of illustration of specific embodiments in which the invention may be practiced. These embodiments are described in sufficient detail to enable those skilled in the art to practice the invention, and it is to be understood that other embodiments may be utilized, and that structural, logical and electrical changes may be made without departing from the spirit and scope of the present invention.

The terms "wafer" and "substrate" are to be understood as including silicon, silicon-on-insulator (SOI), or silicon-on-sapphire (SOS) technology, doped and undoped semiconductors, epitaxial layers of silicon supported by a base semiconductor foundation, and other semiconductor structures. Furthermore, when reference is made to a "wafer" or "substrate" in the following description, previous process steps may have been utilized to form regions or junctions in the base semiconductor structure or foundation. In addition, the semiconductor need not be silicon-based, but could be based on silicon-germanium, germanium, or gallium-arsenide.

The term "pixel" refers to a picture element unit cell containing a photosensor and transistors for converting electromagnetic radiation to an electrical signal. For purposes of illustration, a representative pixel is illustrated in the figures and description herein, and typically fabrication of all pixels in an image sensor will proceed simultaneously in a similar fashion.

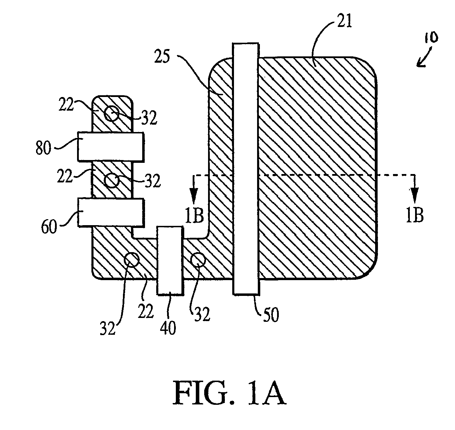

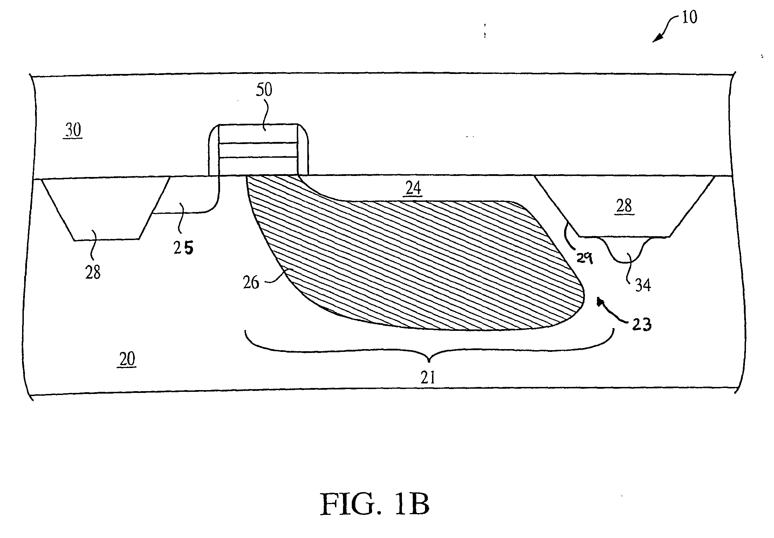

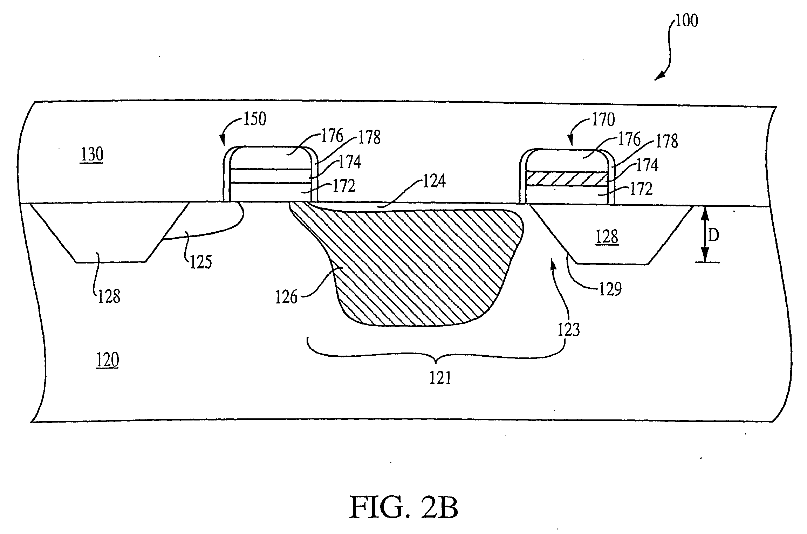

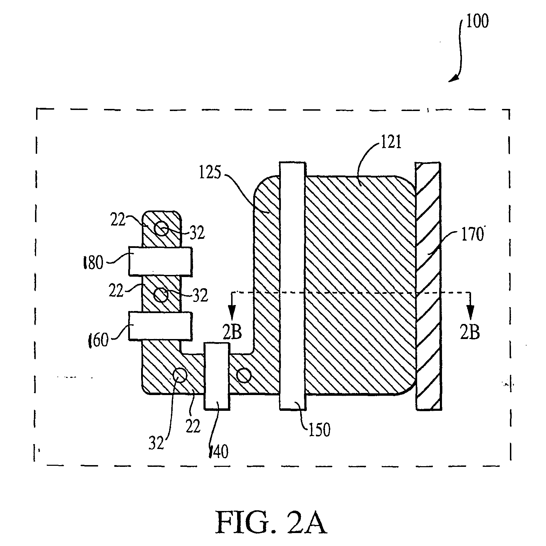

Applicants propose several isolation techniques to isolate areas of semiconductor devices and, in exemplary embodiments, minimize dark current and suppress leakage current in CMOS image sensors, as described below with reference to FIGS. 2-18. To better illustrate these techniques, a brief description of an exemplary CMOS image sensor pixel is described first with reference to FIGS. 1A and 1B. However, it should be noted that the invention is not limited to CMOS image sensors and may be used in any suitable device, for example, a DRAM, flash memory, SRAM, microprocessor, DSP or ASIC.

Referring now to FIGS. 1A and 1B, a semiconductor wafer fragment of an exemplary CMOS image sensor four-transistor (4T) pixel, generally designated by reference numeral 10, is shown. It should be noted that while FIGS. 1A-1B show the use of a transfer gate 50 and associated transistor, the transfer gate 50 provides advantages, but is not required. Thus, the invention may be used in any CMOS imager including, for example, a three transistor (3T) environment where the transfer gate is omitted and an n-type charge collection region of a photodiode is connected with an n-type diffusion region 21. The CMOS image sensor 10 generally comprises a charge collection region 21 for collecting charges generated by light incident on the pixel and transfer gate 50 for transferring photoelectric charges from the collection region 21 to a sensing node, typically a floating diffusion region 25. The floating diffusion region is electrically connected to the gate of an output source follower transistor. The pixel also includes a reset transistor 40 for resetting the sensing node to a predetermined voltage before sensing a signal, a source follower transistor 60, which receives at its gate an electrical signal from the floating diffusion region 25, and a row select transistor 80 for outputting a signal from the source follower transistor 60 to an output terminal in response to an address signal.

The exemplary CMOS image sensor uses a pinned photodiode as the charge collection region 21. The pinned photodiode is termed such since the potential in the photodiode is pinned to a constant value when the photodiode is fully depleted. The pinned photodiode has a photosensitive or p-n-p junction region comprising a p-type surface layer 24 and an n-type photodiode region 26 within a p-type active layer 20. The pinned photodiode includes two p-type regions 20, 24 so that the n-type photodiode region is fully depleted at a pinning voltage. Impurity doped source/drain regions 22, preferably having n-type conductivity, are provided about the transistor gates 40, 60, 80. The floating diffusion region 25 adjacent to transfer gate 50 is also preferable n-type.

In a typical CMOS image sensor, trench isolation regions 28 formed in the active layer 20 are used to isolate the pixels. FIG. 1B illustrates typical STI isolation trenches 28. The trench isolation regions 28 are formed using a typical STI process and are generally formed by etching a trench in the doped active layer or substrate 20 via a directional etching process, such as Reactive Ion Etching (RIE), or etching with a preferential anisotropic etchant used to etch into the doped active layer 20 to a sufficient depth, generally about 1000 to 5000 Angstroms.

The trenches are then filled with an insulating material, for example, silicon dioxide, silicon nitride, ON (oxide-nitride), NO (nitride-oxide), or ONO (oxide-nitride-oxide). The insulating materials may be formed by various chemical vapor deposition (CVD) techniques such as low pressure chemical vapor deposition (LPCVD), high density plasma (HDP) deposition, or any other suitable method for depositing an insulating material within a trench. After the trenches are filled with an insulating material, a planarizing process such as chemical mechanical polishing is used to planarize the structure. While the trench isolation regions 28 are formed by the STI process, it should be understood that the isolation regions 28 may instead be formed using the Local Oxidation of Silicon (LOCOS) process.

The gate stacks for the pixel transistors are formed before or after the trench is etched. The order of these preliminary process steps may be varied as is required or convenient for a particular process flow, for example, if a known photogate sensor (not shown) which overlaps the transfer gate is desired, the gate stacks must be formed before the photogate, but if a non-overlapping photogate is desired, the gate stacks may be formed after photogate formation.

A translucent or transparent insulating layer 30 is formed over the CMOS image sensor. Conventional processing methods are then carried out to form, for example, contacts 32 (shown in FIG. 1A) in the insulating layer 30 to provide an electrical connection to the source/drain regions 22, the floating diffusion region 25, and other wiring to connect gate lines and other connections in the pixel 10. For example, the entire surface may then be covered with a passivation layer of e.g., silicon dioxide, BSG, PSG, or BPSG, which is planarized and etched to provide contact holes, which are then metallized to provide contacts to the photogate (if used), reset gate, and transfer gate.

In CMOS image sensor pixels depicted in FIGS. 1A and 1B, electrons are generated by light incident externally and stored in the n-type photodiode region 26. These charges are transferred to the diffusion region 25 by the gate structure 50 of the transfer transistor. The source follower transistor produces an output signal from the transferred charges. A maximum output signal is proportional to the number of electrons extracted from the n-type photodiode region 26. The maximum output signal increases with increased electron capacitance or acceptability of the photodiode. The electron capacity of pinned photodiodes typically depends on doping levels and the dopants implanted to form regions 24, 26, 20.

A common problem associated with an image sensor pinned photodiode is the creation of dark current in an electrical connection region 23 along the sidewall 29 of the conventional trench isolation region 28. The electrical connection region 23 provides an electrical connection between the p-type surface layer 24 and the p-type active layer 20. Higher dopant concentrations increase the flow of holes through the connection region 23 which increases the electron accumulation capacity of the photodiode. Dark current is strongly dependent on the doping implantation conditions of the CMOS image sensor. However, the higher dopant concentrations used in conventional image sensors also increase dark current in the electrical connection region 23. Embodiments of the invention provide novel techniques for improved electrical connection along the electrical connection region 23 without having to increase dopant concentrations.

Another problem associated with CMOS image sensors may occur when ion implantation is used to further enhance isolation. The polysilicon gates, trench isolation regions, source/drain regions, and diffusion regions may be heavily doped after various fabrication steps via a masked ion implantation. In addition to this doping, in conventional processes, once the trench isolation regions have been formed, a masked ion implant is performed to implant ions in the areas of the substrate directly beneath the trench isolation region thus forming an implanted ion profile 34 (as shown in FIG. 1B). However, increased ion implants or doping results in an increased flat band or threshold voltage shift.

There are limits to the amount of threshold voltage shift Vₜ that a device will tolerate before it will fail. A reference or supply voltage, for example, V_{DD}, to voltage shift Vₜ margin dictates the speed of a CMOS image sensor. Accordingly, it would be ideal to have a threshold voltage shift that is as low as possible. For example, a threshold voltage shift of 0.25mV or less is desirable for CMOS image sensors. The invention further provides novel techniques for reducing threshold voltage shifts. Although the invention is described below for use in a CMOS image sensor as the preferred embodiment, the invention is not limited to such and may be used in any suitable image sensor, for example, a CCD sensor.

A first embodiment according to the invention is now described with reference to FIGS. 2A and 2B. A region rich in positively charged holes is created along the STI sidewall 129 without increasing the dopant levels of the active layer 120. As shown in FIGS. 2A and 2B, an isolation gate 170 is provided over the trench isolation region 128 and adjacent to the p-n-p junction region 121 in order to provide separation between adjacent pixels 100. The isolation gate 170 is preferably also provided slightly over an electrical connection region 123 to provide hole accumulation in this region 123. The isolation gate 170 is preferably a stacked gate including an insulating layer 176 formed over an electrode layer 174 provided over a gate oxide layer 172. Oxide, nitride, or other insulating spacers 178 are provided on either side of the isolation gate 170.

The electrode layer 174 of the isolation gate 170 may be any type of conductor compatible with the CMOS image sensor materials chosen, and is preferably formed of the same material as the other gates. Suitable materials for the electrode layer 174 include, polysilicon, poly/TiSi₂, poly/WSi₂, poly/WNₓ/W, poly /WNₓ, poly/CoSi₂ and poly/MOSi₂. The isolation gate 170 may be formed at the same time as other gates, for example, the isolation gate 170, reset gate 140, the source follower 160, and the transfer gate 150 may be formed at the same time. In processes where the isolation gate 170 is formed at the same time as the other gates, it is preferred that the isolation trench regions 128 are formed prior to formation of the gates, and accordingly it is preferred that the isolation gate 170 is formed subsequent the formation of the underlying isolation trench regions 128. A translucent or transparent insulating layer 130 is formed over the CMOS image sensor. Conventional processing steps may then be carried out to complete formation of the image sensor.

The isolation gate 170 is biased by providing a grounded potential or applying a slight potential to the isolation gate. The potential may be positive or negative depending on the conductivity of the gate type electrode as explained below. Biasing the isolation gate provides electrical isolation between adjacent pixels separated by the isolation gate 170 and corresponding isolation region 128 by causing holes to accumulate in the electrical connection region 123. The accumulation of holes increases the area of the electrical connection region 123 by creating a greater separation between the photodiode region 126 and the STI sidewall 129. The accumulation of holes in the electrical connection region 123 also provides a good electrical connection from the p-type surface layer 124 to the p-type active layer 120.

Furthermore, the depth D of the trench isolation region 128 may be reduced when an isolation gate 170 is used in accordance with the invention. Generally, isolation trenches have a depth of about 2500Å. However, the use of an isolation gate in accordance with the invention allows for the use of a trench having a depth D of less than about 2000Å or the use of an isolation trench may be eliminated. Thus the isolation gate 170 may be formed over the active layer 120.

In accordance with the first illustrated embodiment of the invention, where doping of the source/drain regions (not shown) and the floating diffusion region 125 are doped with an n+ type conductivity material, the electrode layer 174 of the isolation gate electrode 170 is preferably n+ type polysilicon. The isolation gate 170 may be grounded or tied to a slightly negative low reference voltage. The grounded or slightly negative voltage will cause holes to accumulate under the gate in the electrical connection region 123 and provide effective isolation between pixels.

Accordingly, and also in conformance with the first embodiment of the invention, the electrode layer 174 of the isolation gate 170 may be formed of a p-type conductivity material, for example p+ polysilicon. P-type dopants have a lower penetration shift than n-type dopants. However, the use of p-type polysilicon gates shifts the CMOS threshold voltage to more positive values. The combination of the threshold voltage shift associated with the p-type polysilicon gate dopant and the threshold voltage shift associated with additional ion implant doping is excessive and leads to device failure.

Contrary to conventional processes, the present invention does not require additional implants, such as, the implanted ion profile in the areas of the substrate directly beneath the trench isolation region. Therefore, by providing an isolation gate 170 according to the invention to enhance isolation, instead of increasing active layer dopant concentrations, a p+ polysilicon gate may be used without exceeding threshold voltage limitations.

The p+ polysilicon isolation gate may be grounded or tied to a slightly positive voltage, for example, a voltage at or lower than supply voltage V_{DD}, to create holes along the trench sidewall and ensure that a conductive channel for electrons is not formed between pixels. A slightly positive voltage will cause the conductive channel connecting the pixels to become inverted. The grounded voltage will cause holes to accumulate in the electrical connection region 123.

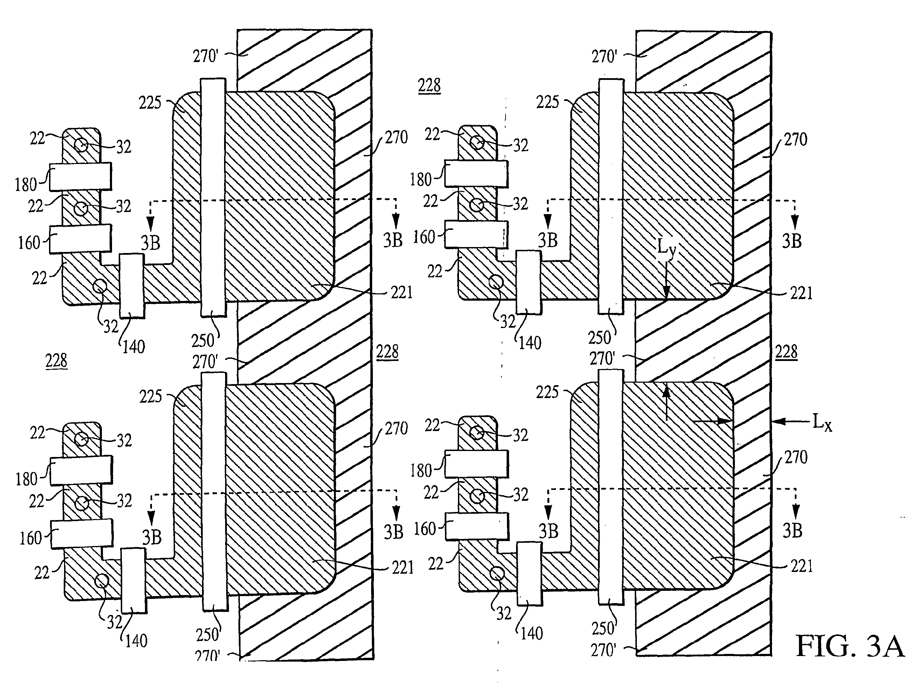

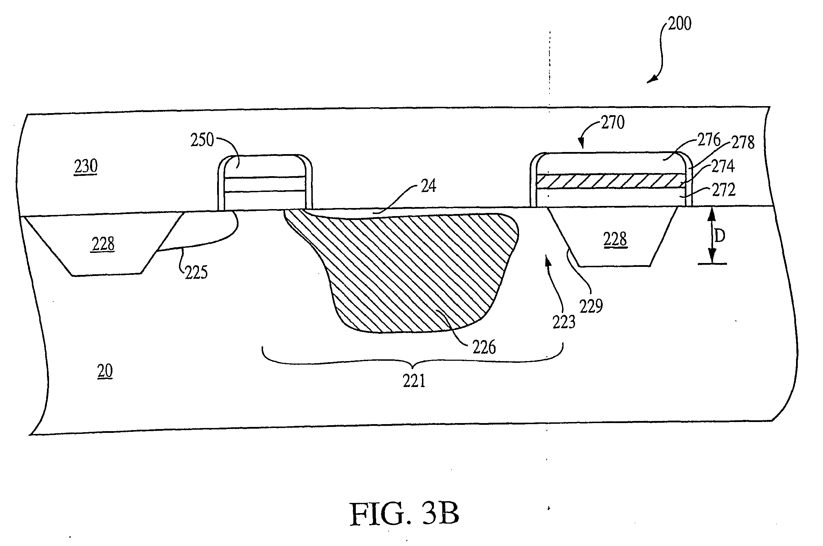

A second embodiment according to the invention is now described with reference to FIGS. 3A and 3B. A 2 x 2 CMOS image sensor pixel array is shown in FIG. 3A to better illustrate the embodiment of the invention. In accordance with the second embodiment of the invention, a region rich in positively charged holes is created along the STI sidewall 229 by providing an isolation gate 270 over the trench isolation region 228 and surrounding the p-n-p junction region 221. The isolation gate 270 is preferably provided slightly over an electrical connection region 223. The isolation gate 270 is also preferably formed to extend around the p-n-p junction region 221 to a gate, for example, transfer gate 250, but does not contact the transfer gate, so as not to short the gates. The isolation gate 270 has a length Lₓ in the x-direction and length L_{y} in the y-direction as shown in FIG. 3A, each of which can be modified to optimize isolation. For example, the length Lₓ and L_{y} of the isolation gate 270 may be independently increased or decreased to minimize dark current and cross-talk between adjacent pixels. The isolation gate 270 preferably does not extend around the floating diffusion region 225. Preferably, the isolation gate 270 extends between pixels 200, as indicated by reference numeral 270'. As shown in FIG. 3B, the isolation gate 270 may be formed over a substantial portion of the trench isolation region 228, thus allowing the formation of a shallower trench isolation region 228 that is less than about 2000 Angstroms deep as discussed above in the description of the first embodiment,

As discussed above, the isolation gate 270 may be formed of any conductive material but is preferably formed of the same material as the other gates. The isolation gate 270 may also be formed at the same time as other gates. In processes where the isolation gate 270 is formed at the same time as the other gates, it is preferred that the isolation trench regions 228 are formed prior to formation of the gates, and accordingly it is preferred that the isolation gate 270 is formed subsequent to the formation of the underlying isolation trench regions 228. A translucent or transparent insulating layer 230 is formed over the CMOS image sensor. Conventional processing steps may then be carried out to complete the image sensor. The isolation gate 270 is also biased by providing a grounded potential or applying a slight potential to the isolation gate. The potential may be positive or negative depending on the conductivity of the gate electrode layer as described below. Biasing the isolation gate provides electrical isolation between adjacent pixels separated by the isolation gate and creates accumulation of holes in the electrical connection region 223.

Also as discussed above, the isolation gate 270 is preferably a stacked gate including an insulating layer 276 formed over an electrode layer 274 provided over a gate oxide layer 272. Oxide, nitride, or other insulating spacers 278 are provided on either side of the isolation gate 270. Where doping of the source/drain region is n-type, the electrode layer 274 of the isolation gate 270, is preferably n+ polysilicon and may be grounded or tied to a slightly negative low reference voltage. Accordingly, and as explained above, the isolation gate 270 may alternatively be a p+ polysilicon gate and may be grounded or tied to a slightly positive reference voltage, for example, V_{DD}. Again the accumulation of holes causes the electrical connection region 223 to expand, thereby providing a greater distance between the photodiode region 226 and the trench sidewalls 229, where trap sites exist.

A simplified circuit for a CMOS image sensor is described below in accordance with the invention. The circuit, includes, for example, a photodiode for accumulating photo-generated charge in an underlying portion of the substrate. It should be understood that the CMOS image sensor may include a photogate, photoconductor, or other image to charge converting device, in lieu of a photodiode, as the initial accumulator for photo-generated charge.

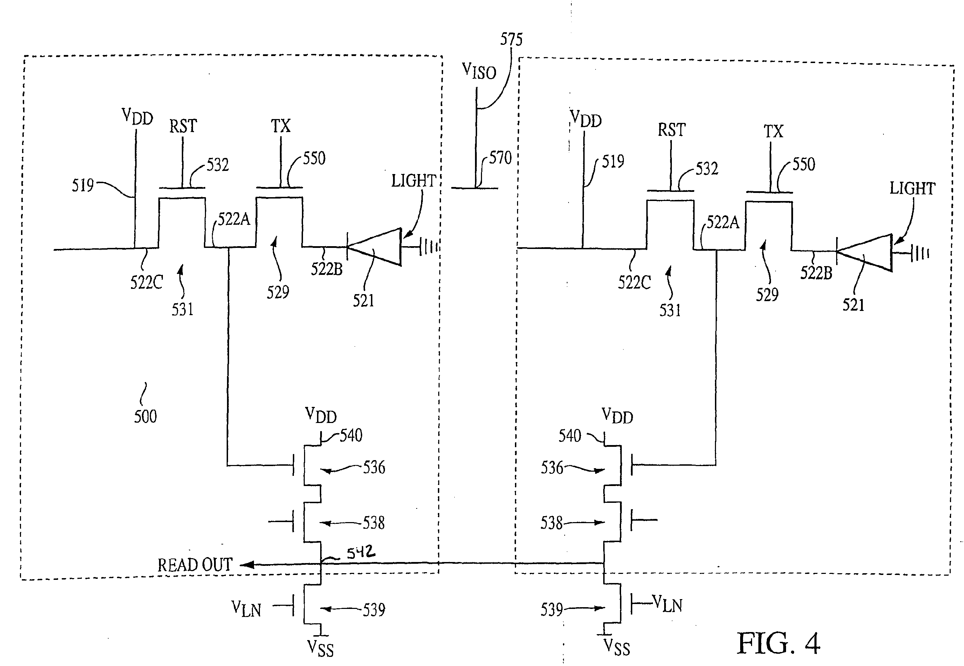

Referring now to FIG. 4, which shows a circuit for a 1x1 portion of a pixel array with each pixel cell being constructed in a manner shown by either of the pixels 100, 200 of FIGS. 2A-3B. The circuit of FIG. 4 shows a CMOS image sensor using a photodiode and having a pixel photodetector circuit.

The photodetector circuit is shown in part as a cross-sectional view of a CMOS image sensor. Each pixel 500 comprises a pinned photodiode 521 for performing photoelectric conversion. Transfer gates 550 are formed between n-type source/drain regions 522A, 522B. The transfer gate 550 and n-type source/drain regions 522A, 522B form the charge transfer transistors 529, which are controlled by a transfer signal TX. The n-type region 522A acts as a floating diffuison region. Reset gates 532 are formed between the n-type source/drain regions 522A, 522C. The reset gates and the source/drain regions 522A, 522C form reset transistors 531, which are controlled by a reset signal RST. The n-type source/drain region 522C is coupled to a voltage source V_{DD} via a conductor 519. It should be noted that while FIG. 4 shows the use of a transfer gate 550 and associated transistor 529, the transfer transistor 529 provides advantages, but is not required. Thus, the invention may be used in a three transistor (3T) environment where the transfer gate is omitted and the n-type charge collection region of the photodiode is converted with the n-type diffusion region 522A.

Isolation is provided between adjacent pixels by an isolation gate 570. The isolation gate 570 is coupled to a reference voltage V_{ISO}. The reference voltage V_{ISO} biases the isolation gate 570 off to accumulate holes in the electrical connection regions of the pixels. Typically, the isolation gate 570 is biased by tying the reference voltage V_{ISO} to ground potential. Where an n-type material is used to form the isolation gate 570, the isolation gate 570 can be turned off "harder" by setting the reference voltage V_{ISO} to a voltage more negative than ground. Alternatively, where a p-type isolation gate 570 is used, the isolation gate 570 can be turned off "harder" by setting the reference voltage V_{ISO} to a voltage more positive than ground. Applying a voltage that is more negative (for n-type isolation gates) or more positive (for p-type isolation gates) than ground will turn the isolation transistor off harder to help turn off a sub-threshold leakage path. Accordingly, a supply voltage V_{DD} can be used to provide a more positive potential. A typical supply voltage can range up to about 5 volts. The isolation gate 570 is provided to prevent leakage between adjacent pixels 500. Therefore, while illustrated as lying between adjacent pixels 500, it should be understood that the isolation gate 570 can be applied anywhere on the device calculated to prevent leakage effects of one pixel 500 to the next.

Each pixel 500 also includes additional transistors, for example, a source follower transistor 536 and a row select transistor 538. The transistors 536, 538 are coupled in series source to drain, with the source of the source follower transistors 536 also coupled over leads 540 to the voltage source V_{DD} and the drain of the row select transistors 538 coupled to leads 542. The drain of the row select transistors 538 are connected via leads 542 to the drains of similar row select transistors for other pixels in a given pixel row. Load transistors 539 are also coupled between the drains of the transistors 538 and a voltage source V_{SS}. The transistors 539 are kept on by a signal V_{LN} applied to their gates.

It should be noted that in many transistors, the source and drain are essentially interchangeable, and interconnections specified herein should not be interpreted as solely limited to those described. In addition, while the transistors have been described as n-type or n-channel, it is recognized by those skilled in the art that a p-type or p-channel transistor may also be used if the structures are uniformly oppositely doped from that described. The n and p designations are used in the common manner to designate donor and acceptor type impurities which promote electron and hole type carriers respectively as the majority carriers. The "+" symbol, when used as a suffix with an impurity type shall be interpreted to mean that the doping concentration of that impurity is heavier than the doping associated with just the letter identifying the impurity type without the "+" suffix.

Another problem associated with the shallow trench isolation technique of the prior art is photon diffusion under the shallow trench isolation structure from one pixel to an adjacent pixel. Attempts have been made to enhance isolation by implanting ions beneath the shallow trench isolation structure. However, these implants result in high current leakage. The invention provides a novel technique for improved isolation between adjacent pixels that does not require additional implants beneath the trench, thereby minimizing the generation of dark current in the CMOS image sensor.

Another consideration in CMOS image sensor fabrication are isolation design rules are constructed to make sure that there is enough margin to prevent punch-through in CMOS circuits. For example, the trench 28 (FIG. 1B) separates the source/drain regions 22 (FIG. 1A) of one pixel from the active layer of an adjacent pixel. Accordingly shallow trenches are generally sufficiently wide to allow a margin adequate enough to prevent punch-through or current leakage. The invention further provides novel techniques for preventing current leakage while allowing tighter design rules in CMOS circuits.

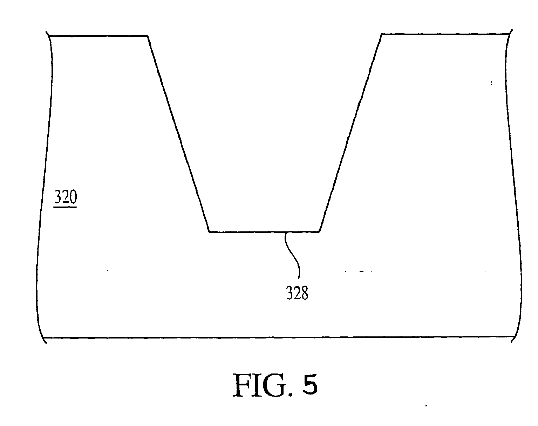

Another embodiment according to the invention is now described with reference to FIGS. 5-9. Applicants propose an STI process, which uses an isolation trench filled with a doped conductive material containing silicon. Shallow trench isolation regions for CMOS image sensors generally have a depth of less than about 3000 Angstroms and generally around about 2000 to about 2500 Angstroms. Typically, shallow trench regions are filled with a conventional insulator, such as oxides or high density plasma (HDP) oxides. However, it is difficult to fill trenches having a depth greater than 2500 Angstroms with conventional insulators due to the limited spacing within the trench, for example, undesirable voids or air gaps are formed when oxides are used to fill trenches having a depth greater than about 2500 Angstroms. In accordance with a third embodiment of the invention, Applicants propose filling trenches with conductive materials containing silicon, preferably polysilicon or silicon-germanium. Conductive materials containing silicon may be easily deposited into trenches of various depths, unlike conventional insulation materials, e.g., silicon dioxide, silicon nitride, NO, ON, HDP, and ONO, which are difficult to fill in deep trenches. Thus, using a conductive material containing silicon to fill the trench 328 will allow easy formation of a trench, particularly, a deep trench having a depth greater than about 2000 Angstroms, and preferably about 4000 to about 5000 Angstroms.

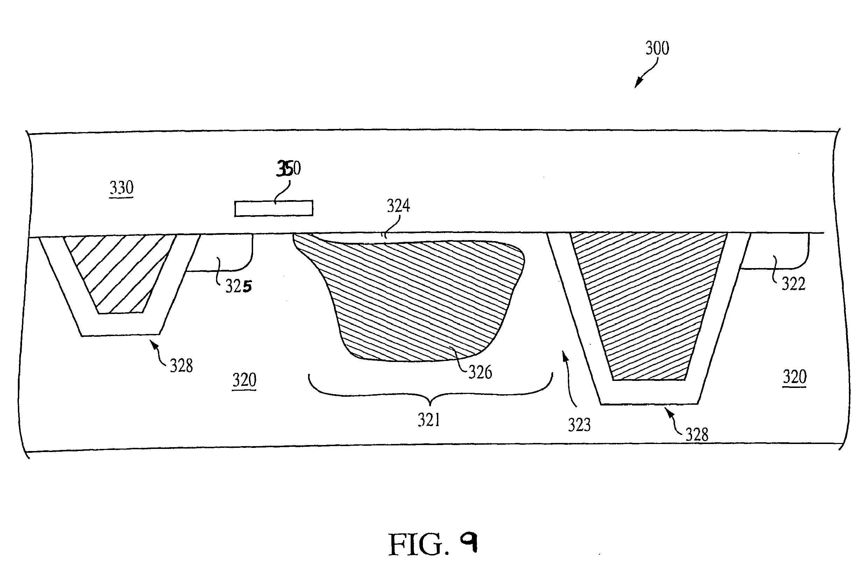

Generally, the deeper the trench the better the isolation. With respect to CMOS image sensors in particular, the deeper the trench the higher the electron storage capacitance of the CMOS image sensor. A trench according to the invention is deeper than a shallow trench, and accordingly has longer sidewalls than a shallow trench. Therefore, the longer sidewalls allow for a larger electrical connection region 323 (FIG. 9) along the sidewalls of the trench such that electron storage capacitance, e.g., hole accumulation, in the electrical connection region 323 is increased in accordance with the invention.

In a CMOS image sensor having a trench filled with a conductive material containing silicon in accordance with the present invention, as shown in FIG. 5, a trench 328 is etched into a doped active layer 320. A resist and mask are applied, and photolithographic techniques are used to define the area to be etched-out. A directional etching process, such as Reactive Ion Etching (RIE), or etching with a preferential anisotropic etchant is used to etch into the doped active layer 320 to form the trench 328. The resist and mask are removed leaving a structure that appears as shown in FIG. 5.

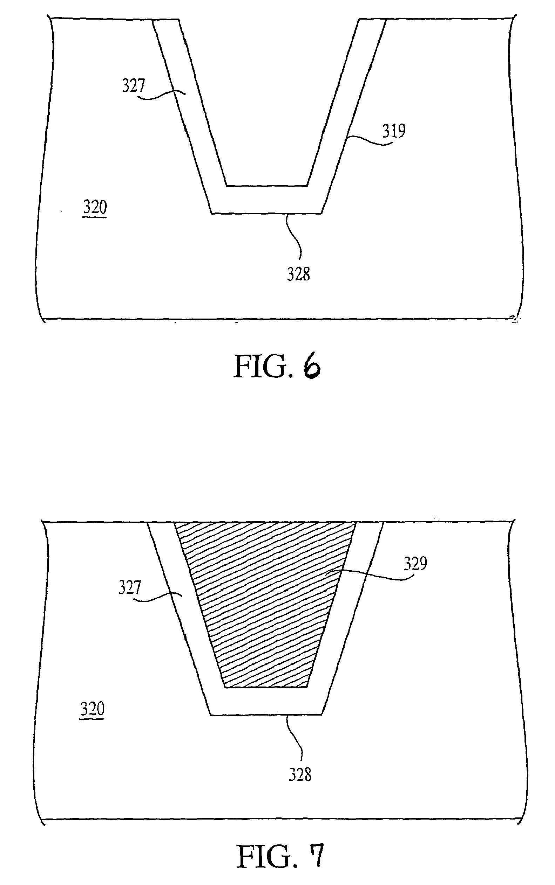

Referring now to FIG. 6, an oxide, i.e., SiO₂ or other dielectric liner 327 is grown within the trench 328. The oxide liner may be formed of NO, ON, or ONO among many other suitable materials. The dielectric liner 327 may be substantially conformal. In other words, the thickness of the liner 327 is substantially the same along the sidewalls 319 and at the bottom of the trench 328. In general, the thickness of the dielectric liner 327 along the sidewalls should be at least about 100 Angstroms.

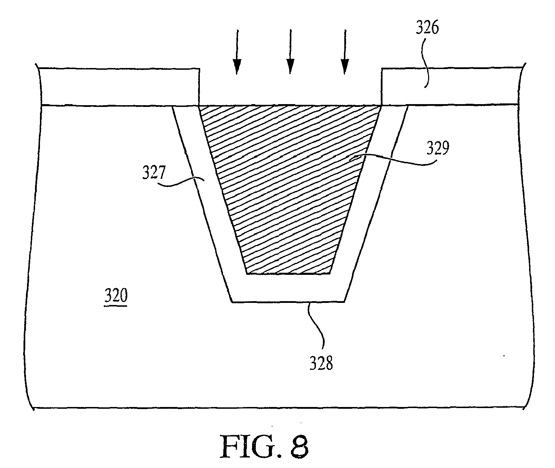

Referring now to FIG. 7, a highly doped (in-situ doped) n-type or p-type conductive material containing silicon 329 is deposited to fill the trench 328. Suitable conductive materials containing silicon include polysilicon and silicon-germanium. Alternatively, as shown in FIG. 8, the trench 328 may be filled with a conductive material containing silicon 329 then, a masked ion implant (indicated by arrows) may be performed to dope the conductive material containing silicon. For example, in the case of a p-type active layer 320, with p-type wells, p-type ions such as boron (B) can be implanted into the conductive material containing silicon using a photoresist mask 326. Similarly, in the case of an n-type active layer 320 with n-type wells, n-type ions such as phosphorous (P), arsenic (As), or antimony (Sb) can be implanted.

Conductive materials containing silicon are easily filled into deep trenches. The deeper the trench, the harder it is to fill the trench with conventional insulators. Oxides and other conventional insulators form voids or air gaps when used to fill deep trenches. However, in accordance with the invention, a trench may be filled with a conductive material containing silicon easily and effectively.

An exemplary CMOS image sensor in accordance with the invention and having a pinned photodiode 321 is shown in FIG. 9. The pinned photodiode 321 has a p-type surface layer 324 and an n-type photodiode region 326 within a p-type active layer 320. A junction is formed around the entirety of the n-type region 326. An impurity doped floating diffusion region 325, preferably having n-type conductivity, is provided on one side of the channel region of transfer gate 350, the other side of which has a portion of n-type region 326. A trench isolation region 328 is formed in the active layer 320 adjacent to, but spaced from the n-type region 321. An electrical connection region 323 for providing hole accumulation is formed adjacent the sidewalls of the trench isolation region 328. The trench isolation region 328 is formed as described above with respect to FIGS. 5-8.

The gate stacks, for example the transfer gate 350, may be formed before or after the trench is etched. The order of these process steps may be varied as is required or convenient for a particular process flow, for example, if a photogate sensor which overlaps the transfer gate is desired, the gate stacks must be formed before the photogate, but if a non-overlapping photogate is desired, the gate stacks may be formed after photogate formation. It should be noted that the entire transfer gate stack is not shown in FIG. 9 for clarity purposes.

A translucent or transparent insulating layer 330 is formed over the CMOS image sensor 300. Conventional processing methods are then carried out to form for example, contacts (not shown) in the insulating layer 330 to provide an electrical connection to the source/drain region 322, the floating diffusion region 325, and other wiring to connect gate lines and other connections in the sensor 300. For example, the entire surface may then be covered with a passivation layer, of e.g., silicon dioxide, BSG, PSG, or BPSG, which is CMP planarized and etched to provide contact holes, which are then metallized to provide contacts to the photogate (if used), reset gate, and transfer gate.

The use of a trench in accordance with the invention provides improved isolation between pixels. The deeper trench better inhibits electrons from diffusing under the isolation trench to an adjacent pixel thereby preventing cross-talk between neighboring pixels. Accordingly, by enhancing isolation via a deeper trench, additional implants under the trench are not necessary, therefore by reducing the implants needed for isolation, current leakage is also reduced. Another advantage of the illustrated embodiment of the invention, is that the use of a deep trench filled with a conductive material containing silicon in accordance with the invention provides a deeper hole accumulation region, thereby increasing electron storage capacity. Also the deeper trench allows for tighter isolation design rules. Deeper trenches may also be narrower than shallow trenches, while still providing effective isolation between neighboring regions. Accordingly, the source/drain regions of one pixel may be brought closer to the active layer of an adjacent pixel, by narrowing the width of the deep trench.

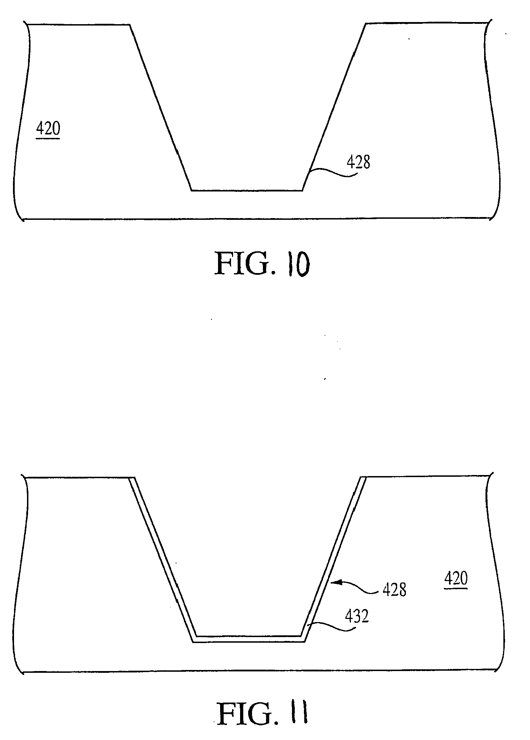

Another embodiment in accordance with the invention is now described with reference to FIGS. 10-16. Referring now to FIG. 10, a trench 428 is etched into an active layer 420. The trench is preferably a deep trench having a depth greater than about 2500 Angstroms and preferably between about 4000 to about 5000 Angstroms. A resist and mask are applied, and photolithographic techniques are used to define the area to be etched-out. A directional etching process, such as RIE, or etching with a preferential anisotropic etchant is used to etch into the doped active layer 420 to form the trench 428. The resist and mask are removed leaving the FIG. 10 structure.

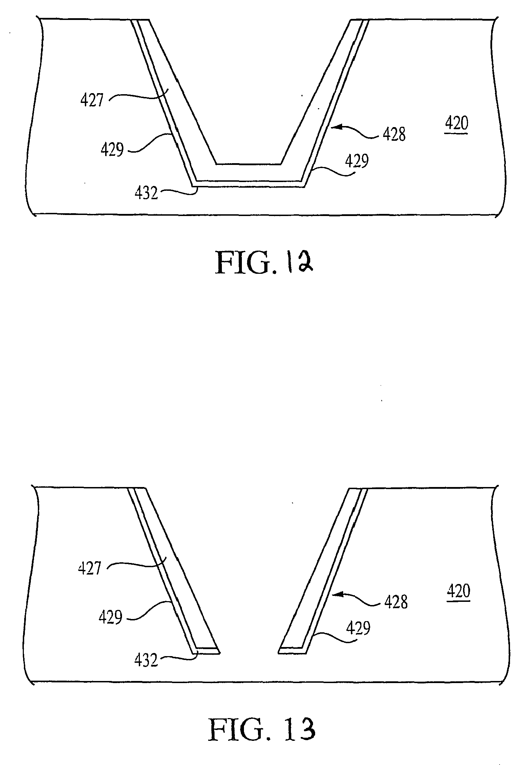

Referring now to FIG. 11, a nitride liner 432 is formed in the trench 428 via Chemical Vapor Deposition (CVD). This nitride liner 432 may be formed of any suitable nitride including NO, ON, ONO, and is preferably formed of silicon nitride.

Referring now to FIG. 12, an oxide, e.g. SiO₂ or other dielectric liner 427 is formed within the trench 428 and over the silicon nitride liner 432. The liner 427 may be non-conformal, in that its thickness may vary along the trench sidewalls 429. A relatively thick liner can be formed near the bottom of the trench and a thinner liner formed near the top of the trench. Non-conforming materials such as the well-known PSG, BPSG, SOG can be used to produce the liner 427.

Referring now to FIG. 13, a bottom portion of the oxide liner 427 and nitride liner 432 is stripped away. This can be accomplished by an anisotropic dry etch or a masked wet or dry etch.

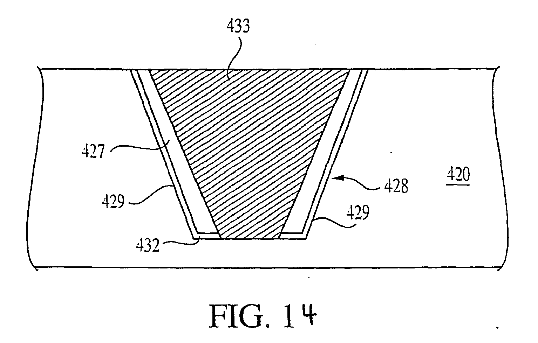

Referring now to FIG. 14, a selective epitaxial layer 433 is grown to fill the trench 428 with silicon. The epitaxial layer 433 may be grown using any suitable technique and may be grown as a single layer or multi-layer. The epitaxial layer 433 is grown in directly on a surface of the active layer 420 so as to provides a direct electrical contact to the doped active layer 420 through the trench while providing improved field isolation between pixels. Providing a direct electrical contact to the active layer in accordance with the invention, eliminates the need for a top contact, therefore saving space and allowing for tighter pixel formation.

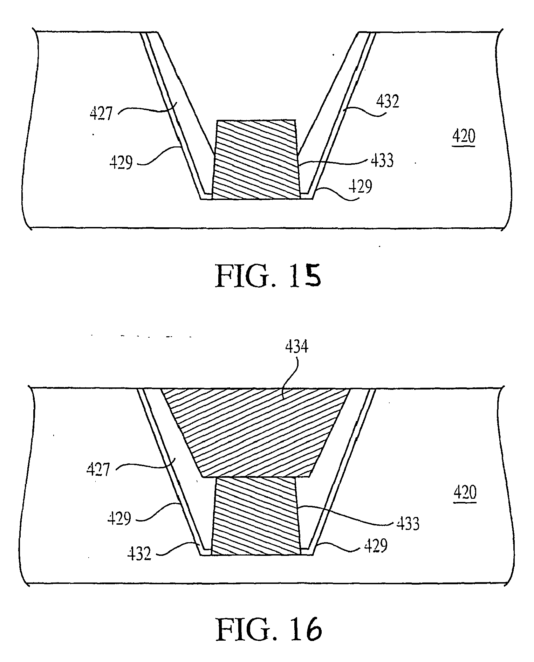

Referring now to FIG. 15, in accordance with yet another embodiment of the invention, the selective epitaxial layer 433 is grown to partially fill the trench 428 with silicon.

Referring now to FIG. 16, a deposition process is performed to fill the rest of the trench with a filler material 434. The filler material is preferably an oxide material and is more preferably an HDP oxide. Alternatively, a conductive material containing silicon, for example polysilicon or silicon-germanium, may also be used to fill the rest of the trench 428.

By providing an epitaxial layer 433, the amount of oxide needed to fill the trench is reduced. Accordingly by using a reduced amount of oxide, or not using oxide in situations where conductive material containing silicon is used to fill the rest of the trench or when the trench is filled with the epitaxial layer 433 (as shown in FIG. 14), a deep trench in accordance with the invention may be formed. As discussed above deep trenches provide improved isolation and in the case of CMOS image sensors, prevention of cross-talk between adjacent pixels. And also as discussed above with regard to the first embodiment, the use of a deep trench to provide improved isolation eliminates the need to use excess implants beneath the trench, thereby reducing dark current in CMOS image sensors caused by current leakage. A selective-EPI filled or partially filled trench according to the invention may be used in combination with other aspects of the invention, for example, the selective-EPI-partially filled trench may be used along with a deep trench filled with a conductive material containing silicon.

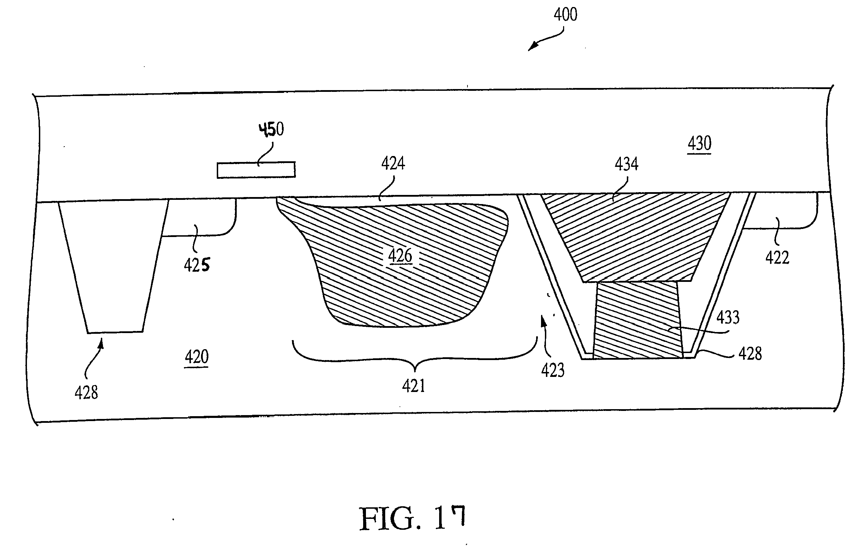

An exemplary CMOS image sensor in accordance with the invention and having a pinned photodiode 421 is shown in FIG. 17. The pinned photodiode 421 has a p-type surface layer 424 and an n-type photodiode region 426 within a p-type active layer 420. A junction is formed around the entirety of the n-type region 426. An impurity doped floating diffusion region 425, preferably having n-type conductivity, is provided on one side of the channel region of transfer gate 450, the other side of which has a portion of n-type region 426. A trench isolation region 428 is formed in the active layer 420 adjacent to but spaced from n-type region 421. An electrical connection region 423 for providing hole accumulation is formed adjacent the sidewalls of the trench isolation region 428. The trench isolation region 428 is formed as described above with respect to FIGS. 10-16. It should be noted that the entire transfer gate stack is not shown in FIG. 17 for clarity purposes.

The gate stacks, for example transfer gate 450, may be formed before or after the trench is etched. The order of these preliminary process steps may be varied as is required or convenient for a particular process flow, for example, if a photogate sensor which overlaps the transfer gate is desired, the gate stacks must be formed before the photogate, but if a non-overlapping photogate is desired, the gate stacks may be formed after photogate formation.

A translucent or transparent insulating layer 430 is formed over the CMOS image sensor 400. Conventional processing methods are then carried out to form for example, contacts (not shown) in the insulating layer 430 to provide an electrical connection to the source/drain region, the floating diffusion region 425, and other wiring to connect gate lines and other connections in the sensor 400. For example, the entire surface may then be covered with a passivation layer, of e.g., silicon dioxide, BSG, PSG, or BPSG, which is CMP planarized and etched to provide contact holes, which are then metallized to provide contacts to the photogate (if used), reset gate, and transfer gate.

Pixel arrays according to the invention, and described with reference to FIGS. 2-17, may be further processed as known in the art to arrive at CMOS image sensors having the functions and features of those discussed with reference to FIGS. 2-17.

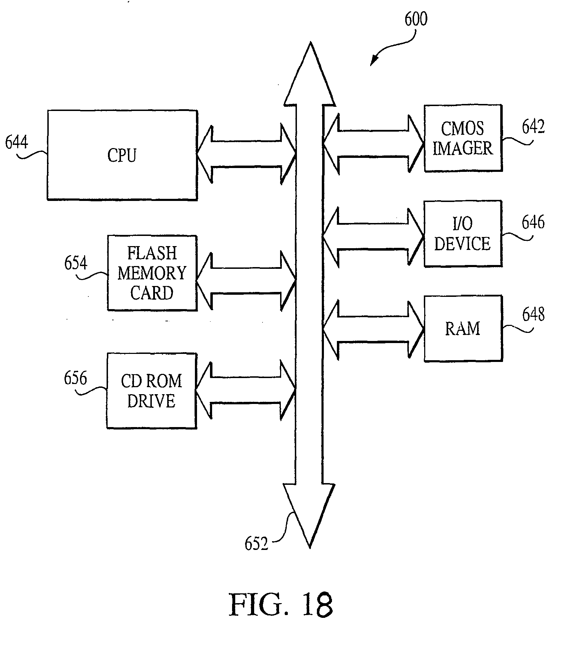

A typical processor based system, which includes a CMOS image sensor according to any embodiment of the invention is illustrated generally at 642 in FIG. 18. A processor based system is exemplary of a system having digital circuits, which could include CMOS image sensors. Without being limiting, such a system could include a computer system, camera system, scanner, machine vision, vehicle navigation, video phone, surveillance system, auto focus system, star tracker system, motion detection system, image stabilization system and data compression system for high-definition television, all of which can utilize the present invention.

A processor based system, such as a computer system, for example generally comprises a central processing unit (CPU) 644, for example, a microprocessor, that communicates with an input/output (I/O) device 646 over a bus 652. The CMOS image sensor 642 also communicates with the system over bus 652. The computer system 600 also includes random access memory (RAM) 648, and, in the case of a computer system may include peripheral devices such as a flash memory card 654, or a compact disk (CD) ROM drive 656 which also communicate with CPU 644 over the bus 652. It may also be desirable to integrate the processor 654, CMOS image sensor 642 and memory 648 on a single IC chip.

The above description and drawings are only to be considered illustrative of exemplary embodiments, which achieve the features and advantages of the invention. Modification and substitutions to specific process conditions and structures can be made without departing from the spirit and scope of the invention. Accordingly, the invention is not to be considered as being limited by the foregoing description and drawings, but is only limited by the scope of the appended claims.

## Claims

1. An image sensor comprising:
a pixel comprising a photosensitive region;
an isolation region adjacent said pixel; and
an isolation gate provided over said isolation region.

2. The sensor of claim 1 wherein said pixel further comprises at least one transistor gate for transferring photoelectric charges from said photosensitive region and wherein said isolation gate is of the same conductivity type as said at least one transistor gate.

3. The sensor of claim 1 wherein said photosensitive region, comprises a p-type conductivity substrate, an n-type conductivity photodiode region, and a p-type conductivity surface region.

4. The sensor of claim 3 wherein said isolation gate extends over at least a portion of a region between said photosensitive region of said pixel and said isolation region and said isolation gate is biased to accumulate holes in said region between said photosensitive region of said pixel and said isolation region.

5. The sensor of claim 1 wherein said isolation gate is biased to provide electrical isolation between adjacent pixels.

6. The sensor of claim 1 wherein said photosensitive region comprises one of a photosensor, photodiode, photogate, and a photoconductor.

7. The sensor of claim 1 wherein said image sensor comprises a CMOS image sensor.

8. The sensor a claim 1 wherein said CMOS image sensor comprises a three transistor (3T) CMOS image sensor.

9. The sensor of claim 1 wherein said CMOS image sensor comprises a four transistor (4T) CMOS image sensor.

10. The sensor of claim 1 wherein said image sensor comprises a CCD image sensor.

11. An image sensor, said image sensor comprising:
an active layer of a first conductivity type formed within a substrate;
at least one transistor gate formed over a portion of said active layer;
a photosensor formed adjacent to said transistor gate;
an isolation region formed in said active layer adjacent to said photosensor; and
an isolation gate formed over at least a portion of said isolation region.

12. The sensor of claim 11 wherein said photosensor comprises a p-n-p junction region formed under said at least one transistor gate, said p-n-p junction region comprising a surface layer of said first conductivity type overlying a photosensitive region of a second conductivity type, said photosensitive region overlying said active layer of said first conductivity type.

13. The sensor of claim 11 wherein said photosensor comprises one of a photodiode, photogate, photoconductor, p-n-p diode, and a buried diode.

14. A processor based system comprising the sensor of claim 11.

15. A CMOS image sensor comprising:
a pixel for receiving incident photo energy and converting it into an electrical signal;
said pixel comprising:
a photosensitive area for accumulating photo-generated charge;
a floating diffusion region adjacent a side of said photosensitive area for receiving charge from said photosensitive area;
a read out circuit comprising at least an output transistor for reading out charge from said floating diffusion region;
an isolation region formed around at least a portion of said pixel; and
an isolation gate formed over at least a portion of said isolation region.

16. The image sensor of claim 15 wherein said isolation gate is of a same conductivity type as a gate of said output transistor.

17. The image sensor of claim 15 wherein said isolation gate is formed over a substantial portion of said isolation region.

18. An image sensor comprising:
a semiconductor substrate having a plurality of image sensor pixels formed thereon;
each of said pixels comprising a photosensitive region and a floating diffusion region;
an active area formed between adjacent pixels; and
at least one isolation gate formed over a portion of said active area.

19. An integrated circuit comprising:
a semiconductor substrate having a plurality of image sensor pixels formed thereon;
each of said pixels comprising a photosensitive region and a floating diffusion region;
an isolation region formed between adjacent pixels;
at least one isolation gate formed over a portion of said isolation region, said isolation gate being biased to a constant voltage such that the isolation gate constantly reverse biases the isolation region.

20. The circuit of claim 19 wherein said pixels further comprise a transfer gate between said photosensitive region and said floating diffusion region.

21. The circuit of claim 20 wherein said transfer gate and said isolation gate are of the same conductivity type.

22. The circuit of claim 19 wherein said isolation gate surrounds a substantial portion of said pixels but does not contact said transfer gate or said floating diffusion region.

23. An image sensor comprising:
a substrate having a doped layer of a first conductivity type; an array of pixel sensor cells formed in said doped layer;
an isolation region formed between each pixel sensor cell; and
an isolation gate formed over a substantial portion of said isolation region, said isolation gate being formed over at least a portion of said doped layer.

24. An integrated circuit comprising:
a semiconductor substrate having an image sensor pixel formed thereon;
said pixel comprising at least one transfer gate disposed over and between a floating diffusion region and a photosensitive active region;
an isolation channel formed in said substrate and between said pixel and an adjacent pixel; and
an isolation gate formed over said isolation channel, whereby said isolation gate extends around substantially all of said photosensitive active region, the isolation gate being biased by a voltage such that the isolation gate biases the isolation channel.

25. A method of forming an image sensor comprising the steps of:
forming a pixel within a substrate;
forming an isolation region adjacent said pixel; and
forming an isolation gate over said isolation region and over at least a portion of a connection region formed adjacent to said isolation region.

26. The method of claim 25 wherein said isolation gate has the same conductivity type as at least one transistor gate of said pixel.

27. The method of claim 25 wherein a length of said isolation gate is adjusted to minimize cross talk between adjacent pixels.

28. A method of operating an image sensor, said image sensor comprising a pixel, an isolation region adjacent said pixel, and an isolation gate provided over said isolation region and adjacent to said pixel said method comprising the steps of: forming a separation between a photodiode region of said pixel and said isolation region by applying a voltage to said isolation gate.

29. The method of claim 28 wherein said method of forming a separation comprises accumulating holes in a connection region between said photodiode region and said insulation region.

30. A method of forming an image sensor comprising:
forming an active layer of a first conductivity type on a substrate;
forming a photosensor in said active layer; and
forming an isolation gate over at least a portion of said active layer adjacent said photosensor.

31. The method of claim 30 comprising forming said isolation gate over a substantial portion of said isolation region.

32. The method of claim 30 further comprising forming a length of said isolation gate to minimize cross-talk between adjacent pixels.

33. The method of claim 30 wherein forming said photosensor comprises forming one of a photodiode, photogate, photoconductor, p-n-p diode and a buried diode.

34. A method of forming a CMOS image sensor comprising:
forming a CMOS image sensor pixel within a substrate; said pixel being formed by:
forming a photosensitive area for accumulating photo-generated charge;
forming a floating diffusion region adjacent one side of said photosensitive area;
forming an output transistor for reading out charge from said floating diffusion region;
forming a read out circuit comprising at least said output transistor;
forming an isolation region around at least a portion of said pixel; and
forming an isolation gate over at least a portion of said isolation region.

35. A method of operating an integrated circuit comprising:
forming a semiconductor substrate;
forming a plurality of image sensor pixels in said substrate; interconnecting said pixels into a circuit;
forming each of said pixels such that each of said pixels comprises a photosensitive region and a floating diffusion region;
forming an isolation region between adjacent pixels; forming at least one isolation gate over at least a portion of said isolation region;
biasing said isolation gate to a constant voltage; and reverse biasing said isolation region by applying said constant voltage.

36. A structure for isolating areas in a semiconductor device,
said structure comprising:
a trench formed in an image sensor substrate between adjacent regions; and
a conductive material deposited within said trench to fill at least a portion of said trench.

37. The structure of claim 36 further comprising an insulating liner formed along at least sidewalls of said trench.

38. The structure of claim 36 wherein said conductive material comprises one of silicon, silicon-germanium, and polysilicon.

39. The structure of claim 36 wherein said trench further comprises an epitaxial layer underlying said conductive material and formed within said trench.

40. The structure of claim 39 wherein said trench has a depth of between about 1000 to about 5000 Angstroms.

41. The structure of claim 39 wherein said trench has a depth of greater than about 2000 Angstroms.

42. The structure of claim 36 wherein said semiconductor device comprises a CMOS image sensor.

43. The structure of claim 36 wherein said conductive material comprises an epitaxial material.

44. A structure for isolating areas in an image sensor, said structure comprising:
a trench formed in an image sensor substrate between adjacent pixels;
an insulating liner formed along walls of said trench; and
a conductive material formed within said insulating liner.

45. The structure of claim 44 wherein said conductive material comprises an epitaxial layer.

46. The structure of claim 45 wherein said epitaxial layer partially fills said trench.

47. The structure of claim 45 further comprising a filler material deposited over said epitaxial layer and within said trench.

48. The structure of claim 45 further comprising a nitride liner formed between said sidewalls of said trench and said insulating liner.

49. The structure of claim 47 wherein said filler material comprises one of an insulating material, a conductive material and silicon.

50. An image sensor comprising:
an active layer of a first conductivity type formed in a substrate;
a charge transfer region formed in said active layer;
a photodiode formed in said active layer adjacent said charge transfer region, said photodiode comprising a region of a second conductivity type between regions of said active layer of said first conductivity type;
a charge collection region in said active layer for receiving charges transferred from said photodiode region;
an isolation region formed adjacent said active layer, said isolation region comprising a trench; and
a conductive material formed within said trench.

51. The sensor of claim 50 further comprising an insulating liner formed along at least sidewalls of said trench.

52. The sensor of claim 50 wherein said conductive material comprises silicon.

53. The sensor of claim 50 wherein said trench has a depth of between about 1000 to about 5000 Angstroms.

54. The sensor of claim 50 wherein said trench has a depth of greater than about 2000 Angstroms.

55. The sensor of claim 50 wherein said conductive material comprises an epitaxial material.

56. The sensor of claim 55 wherein said epitaxial material partially fills said trench.

57. A processing system comprising: (i) a processor; and (ii) a semiconductor device coupled to said processor and including:
a trench formed in a substrate between adjacent regions; and
a conductive material deposited within said trench to fill at
least a portion of said trench.

58. A processing system comprising: (i) a processor; and (ii) an image sensor device coupled to said processor, said image sensor device comprising:
an active layer of a first conductivity type formed in a substrate;
a charge transfer region formed over said substrate;
a photodiode formed adjacent said charge transfer region, said photodiode comprising a region of a second conductivity type sandwiched between regions of said active layer of said first conductivity type;
a charge collection region for receiving charges transferred from said photodiode region;
an isolation region formed adjacent interconnecting first conductivity type portions of said active layer, said isolation region comprising a trench; and
a conductive material formed at least partially within said trench.

59. A method of forming a structure for isolating areas in a semiconductor device, said method comprising:
forming a trench to separate regions of a semiconductor device; and
at least partially filling said trench with a conductive material.

60. The method of claim 59 further comprising forming an insulating liner along at least sidewalls of said trench.

61. The method of claim 59 wherein said conductive material comprises one of silicon, polysilicon, and silicon-germanium.

62. The method of claim 59 further comprising forming an epitaxial layer underlying said conductive material.

63. The method of claim 59 wherein said trench is formed to have a depth of greater than about 2000 Angstroms.

64. A method of forming a structure for isolating areas in a semiconductor device, said method comprising the steps of:
forming an opening in an active area of a semiconductor substrate between adjacent regions;
growing an epitaxial layer in said opening; and
depositing a filler material within said opening and over said epitaxial layer to fill said opening.

65. A method of forming an image sensor, said method comprising the steps of:
forming a substrate;
forming an active layer of a first conductivity type within said substrate;
forming a charge transfer region within said active layer; forming a photodiode within said active layer adjacent said charge transfer region, said step of forming said photodiode comprising forming a region of a second conductivity type between regions of said active layer of said first conductivity type;
forming a charge collection region within said active layer for receiving charges transferred from said photodiode region; and
forming an isolation region adjacent said active layer, by forming a trench at least partially filling said trench with a conductive material.
